# EUROPEAN PATENT SPECIFICATION

(11) **EP 2 649 463 B1**
(45) Date of publication and mention of the grant of the patent: **08.05.2019**
(21) Application number: 11847860.1
(22) Date of filing: 09.12.2011
(51) Int. Cl.: G01R 31/26, G01R 31/28, G01R 1/067, G01R 1/073

(54) **PROBE CARD ASSEMBLIES AND PROBE PINS INCLUDING CARBON NANOTUBES**
SONDENKARTENBAUGRUPPEN UND SONDENSPITZEN MIT KOHLENSTOFFNANORÖHREN
ENSEMBLES DE CARTE DE SONDE ET BROCHES DE SONDE COMPRENANT DES NANOTUBES DE CARBONE

(30) Priority: 09.12.2010 US 421409 P
(43) Date of publication of application: 16.10.2013
(73) Proprietor: Wentworth Laboratories, Inc., Brookfield, CT 06804 (US)
(72) Inventor: BRANDORFF, Alexander, New Milford, CT 06776 (US)
(74) Representative: Weickmann & Weickmann PartmbB
(86) International application number: PCT/US2011/064065
(87) International publication number: WO 2012/078944

(56) References cited:
- WO-A1-2010/037097
- US-A1- 2002 109 514
- US-A1- 2002 109 514
- US-A1- 2004 211 589
- US-A1- 2004 211 589
- US-A1- 2009 002 004
- US-A1- 2009 002 009
- US-A1- 2009 066 352
- US-A1- 2009 066 352
- US-A1- 2009 121 732
- US-A1- 2009 197 484
- US-A1- 2010 083 489
- US-A1- 2010 083 489

## Description

### BACKGROUND

In the computer chip manufacturing industry, it is necessary to test the performance of integrated circuits (IC's) at various points in the manufacturing process, in order to weed out defective components and to monitor the manufacturing process. Various technologies have been employed for this purpose, though all are challenged due to the increasing demands of the IC manufacturing process.

In order to electrically test the circuitry, it is necessary to make contact with pads on the IC, i.e., to "probe" the IC. The probes must be able to align very accurately with the IC pads to be tested, and to provide sufficient current to power the IC as well as provide reliable, low resistance electrical contact at low inductance such that the test signals are not distorted. As IC manufacturing progresses to increasingly smaller geometries, increasing number of transistors, and higher clock frequencies, it challenges the abilities of existing technologies to probe the IC. The smaller geometries result in reduced test pad dimensions, which then require the probes to be better aligned to insure that they do not miss the pads. The increasing number of transistors and higher clock frequencies require that the probes be able to provide an increasing amount of current without burning up or "fusing" the probe, or reducing the probes physical characteristics such as spring force and fatigue life.

IC manufacturers increasingly desire that the IC's be tested at elevated ambient temperature to better simulate worst-case environmental conditions or to perform accelerated life testing. This places an increasing burden on the probe to be able to provide the high current levels at elevated temperatures of 150 degrees Celsius. The increased processing speed of the IC's further requires that the probes have low inductance so as not to distort the clock and signal waveforms that are fed to the IC, and to accurately transfer the waveforms from the IC to the monitoring test equipment.

Some designs in the art include assemblies that combine known conventional vertical buckling beam (VBB) sort interface unit assemblies where the probe head includes an array of curved probes. In such designs, one end of the probes (the "tips") makes contact with the wafer being tested and the other end (the "head") makes contact with the array of contact pads on the "C4" side of the space transformer. The curved shape of the wires allows them to flex and act as springs when making contact with the wafer. The compression of the wires allows them to compensate for wafer height and planarity variations without damaging the wafer pads. The requirement that the probes be flexible complicates the manufacturing of the probes and the assembly of the probe head. It also requires that the wires be relatively long (about 6.35 mm (about ¼" in non-Si units)) in order to limit the mechanical stress in the wire as it flexes.

There are many known testing devices that do not include the use of carbon nanotubes. For example, United States Patent Nos. 6906540, 6756797, and 6297657, all teach various IC testing devices that do not include the use of carbon nanotube technology. Other assemblies include the use of carbon nanotube bundle probes. Such assemblies can provide unique fabrication challenges and difficult repair challenges.

Document US 2009/0066352 A1 discloses columns comprising a plurality of vertically aligned carbon nanotubes which can be configured as electromechanical contact structures or probes. The columns can be grown on a sacrificial substrate and transferred to a product substrate, or the columns can be grown on the product substrate. The columns can be treated to enhance mechanical properties such as stiffness, electrical properties such as electrical conductivity, and/or physical contact characteristics. The columns can be mechanically tuned to have predetermined spring properties.

The columns can be used as electromechanical probes, for example, to contact and test electronic devices such as semiconductor dies, and the columns can make unique marks on terminals of the electronic devices.

Document US 2009/0197484 A1 discloses a composite spring contact structure including a structural component and a conduction component distinct from each other and having differing mechanical and electrical characteristics. The structural component can include a group of carbon nanotubes. A mechanical characteristic of the composite spring contact structure can be dominated by a mechanical characteristic of the structural component, and an electrical characteristic of the composite spring contact structure can be dominated by an electrical characteristic of the conduction component. Composite spring contact structures can be used in probe cards and other electronic devices. Various ways of making contact structures are also disclosed.

Document US 2010/0083489 A1 discloses carbon nanotube columns each comprising carbon nanotubes which can be utilized as electrically conductive contact probes. The columns can be grown, and parameters of a process for growing the columns can be varied while the columns grow to vary mechanical characteristics of the columns along the growth length of the columns. Metal can then be deposited inside and/or on the outside of the columns, which can enhance the electrical conductivity of the columns. The metalized columns can be coupled to terminals of a wiring substrate. Contact tips can be formed at or attached to ends of the columns. The wiring substrate can be combined with other electronic components to form an electrical apparatus in which the carbon nanotube columns can function as contact probes. Document US 2010/0083489 A1 discloses the subject matter of the preamble of claim 1.

Document US 2004/0211589A12002/0109514 A1 discloses a conducting thin-film nanoprobe card fabrication method including the steps of: (a) arranging nanotubes on a substrate in vertical; (b) covering the nanotubes with a liquid polymeric resin and then hardening the polymeric resin to form a conducting nanomembrane; (c) removing a part of the polymeric resin from the conducting nanomembrane to expose one end of each nanotube to outside; (d) removing the substrate and preparing a ceramic substrate having contacts at one side and metal bumps at the other side and plated through holes electrically respectively connected with the contacts and the metal bumps; (e) mounting the nanomembrane on the ceramic substrate to hold the nanotubes in contact with the contacts of the ceramic substrate, and (f) forming recessed holes in the nanomembrane by etching and inserting a metal rod in each recessed hole to form a respective probe.

Document US 2002/0109514 A1 discloses a probe card assembly that compensates for differing rates of thermal expansion. The assembly is comprised of a multi-layered dielectric plate interposed between a probe head and a printed circuit board. The printed circuit board has arrayed upon its surface a first plurality of electrical contacts arranged in a pattern. The dielectric plate has a second plurality of electrical contacts arranged in a pattern matching the first plurality of contacts. A planarizing interposer is interposed between the plate and the printed circuit board and has a pattern of holes matching the pattern of electrical contacts on the printed circuit board and plate. The assembly further includes a plurality of electrical connectors disposed within each of the holes arrayed in a pattern upon the planarizing interposer a plurality conductive bumps or fuzz buttons making electrical contact with the first and second plurality of electrical contacts.

Document US 2009/0002009 A1 discloses an upper die portion of a die head for aligning probes having different offsets in a first array of first micro-holes formed in a lower die portion of the die head. The upper die portion includes a spacer portion and a first assembly aid film. The spacer portion includes first and second surfaces. The first surface contacts the lower die portion. The first assembly aid film is attached with the second surface and has a second array of second micro-holes for receiving the probes having different offsets. The second micro-holes include at least a first micro-hole that is configured to be offset from a corresponding micro-hole of the first micro-holes by a first offset and at least a second micro-hole that is configured to be offset from a corresponding micro-hole of the first micro-holes by a second offset that is not the same as the first offset.

Document US 2009/0121732 A1 discloses a wafer-scale probe card for temporary electrical contact to a sample wafer or other device, for burn-in and test. The card includes a plurality of directly metallized single-walled or multi-walled nanotubes contacting a pre-arranged electrical contact pattern on the probe card substrate. The nanotubes are arranged into bundles for forming electrical contacts between areas of the device under test and the probe card. The bundles are compressible along their length to allow a compressive force to be used for contacting the probe card substrate to the device under test. A strengthening material may be disposed around and/or infiltrate the bundles. The nanotubes forming the bundles may be patterned to provide a pre-determined bundle profile. Tips of the bundles may be metallized with a conductive material to form a conformal coating on the bundles; or metallized with a conductive material to form a continuous, single contact surface.

Document WO 2010/037097 A1 discloses methods of fabricating a plurality of carbon nanotube-bundle probes on a substrate. In some embodiments, the method includes the following: providing a substrate having a top surface and a bottom surface; forming an array of electrically conductive pads on the top surface, the array of electrically conductive pads being formed to mirror an array of pads on an integrated circuit that is to be tested; applying a catalyst for promoting growth of carbon nanotubes on each of the array of electrically conductive pads; heating the substrate in a carbon-rich environment thereby growing nanotubes extending upwardly from each of the array of electrically conductive pads and above the top surface of the substrate thereby forming a plurality of carbon nanotube-bundle probes extending upwardly above the top surface of the substrate; and capping each of the plurality of carbon nanotube-bundle probes with an electrically conductive material.

Document US 2009/0002004 A1 discloses an integrated compound nano probe card to include a substrate layer having a front side and a back side, and compound probe pins arranged in the substrate layer. Each compound probe pin has a bundle of aligned parallel nanotubes/nanorods and a bonding material bonded to the bundle of aligned parallel nanotubes/nanorods and filled in gaps in the nanotubes/nanorods. Each compound probe pin has a base end exposed on the back side of the substrate layer and a distal end spaced above the front side of the substrate layer.

The object of the present invention is to provide a probe card assembly for testing circuit boards with a simple and cost reduced manufacturing process.

The above object is solved according to the invention by a card assembly for testing circuit boards according to claim 1. Preferred embodiments of the invention are described in the dependent claims.

### SUMMARY

One aspect of the disclosed subject matter is a probe card assembly for testing circuit boards. In some embodiments, the assembly includes the following: a multi-layered dielectric plate aligned with an integrated circuit, the integrated circuit having arrayed upon its surface a first plurality of electrical contacts arranged in a pattern, the dielectric plate having arrayed upon its surface a second plurality of electrical contacts arranged in a pattern substantially matching the first plurality of electrical contacts; a carbon nanotube interposer interposed between the dielectric plate and the integrated circuit, the nanotube interposer having compliant nanotubes that are arranged to match the pattern of electrical contacts on the integrated circuit and the dielectric plate; and a plurality of vertical probes arrayed in a pattern upon the nanotube interposer and joined with the carbon nanotubes, the vertical probes making electrical contact with the first plurality of electrical contacts and the second plurality of electrical contacts via the carbon nanotubes.

### BRIEF DESCRIPTION OF THE DRAWINGS

For the purpose of illustrating the invention, the drawings show a form of the disclosed subject matter that is presently preferred. However, it should be understood that the disclosed subject matter is not limited to the precise arrangements and instrumentalities shown in the drawings, wherein:
FIG. 1 is a side elevation view of a probe card assembly including a carbon nanotube interposer according to some embodiments of the disclosed subject matter; and
FIG. 2 is side elevation view of a probe card assembly including probes with raised surfaces according to some embodiments of the disclosed subject matter.

### DETAILED DESCRIPTION

The disclosed subject matter includes probe card assemblies that include arrays of carbon nanotubes incorporated in interposers to bridge the gap between a space transformer and a probe head assembly and provide the necessary compliance when testing with straight, substantially rigid probes.

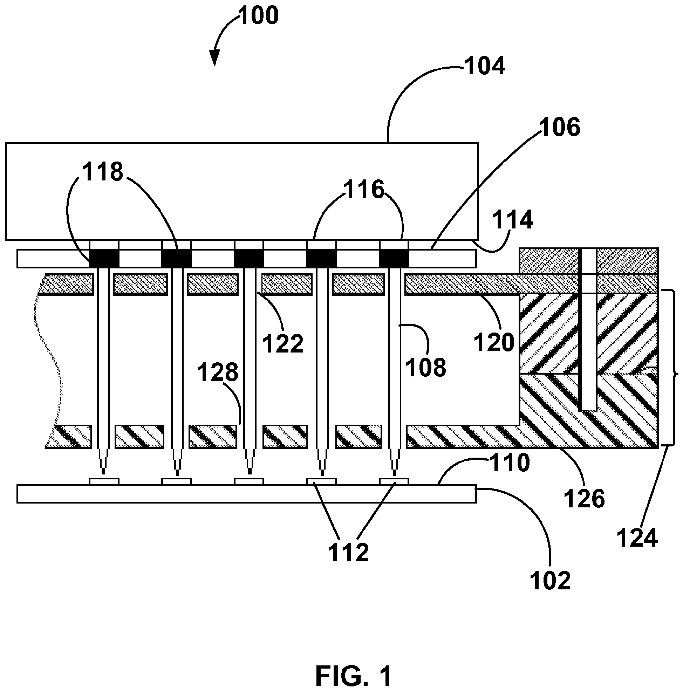

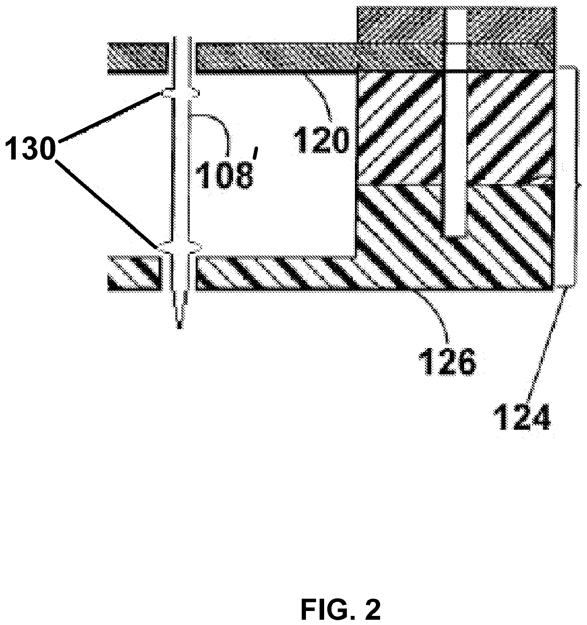

Referring now to FIGS. 1 and 2, some embodiments of the disclosed subject matter include a probe card assembly 100 for testing circuit boards 102, which include a multi-layered dielectric plate 104, a carbon nanotube interposer 106, and a plurality of substantially vertical and rigid probes 108.

Multi-layered dielectric plate 104 is aligned with integrated circuits 102. Integrated circuits 102 has arrayed upon a surface 110 a first plurality of electrical contacts 112 arranged in a pattern. Dielectric plate 104 has arrayed upon a surface 114 a second plurality of electrical contacts 116 arranged in a pattern substantially matching first plurality of electrical contacts 112.

Carbon nanotube interposer 106 is interposed between dielectric plate 104 and integrated circuits 102. Carbon nanotube interposer 106 has compliant carbon nanotubes 118 that are arranged to match the pattern of electrical contacts 112, 116 on integrated circuits 102 and dielectric plate 104, respectively. Carbon nanotubes 118 can be formed by laying down "spots" of vertically-aligned multi-walled carbon nanotubes on pre-patterned substrates by chemical vapor deposition. A prepolymer solution is then added and cured. The material is then peeled away from the substrates to develop a freestanding film material having aligned carbon nanotubes in a transparent polymer matrix.

Plurality of substantially vertical and rigid, i.e., non-compliant, probes 108 are arrayed in a pattern upon nanotube interposer 106 and positioned adjacent or joined with carbon nanotubes 118. Vertical probes 108 make electrical contact with first plurality of electrical contacts 112 and second plurality of electrical contacts 116 via carbon nanotubes 118. Carbon nanotubes 118 serve as the electrical conduit between vertical probes 108 and second plurality of electrical contacts 116. In some embodiments, carbon nanotubes 118 are formed in an array having radial spacing of less than 100 nm. While carbon nanotubes 118 can be custom sized, in some embodiments, each of the carbon nanotubes has a height less than 0.508 mm (20 mils in non-Si units) and each of the carbon nanotube bundles requires less than 8 grams per 0.025 mm (8 grams per mil in non-Si units) of compression.

To facilitate fabrication of probe card assembly 100, a conventional assembly aid film 120 including a first array of holes 122 and a die head 124 including a lower die head 126 having a second array of holes 128 can be used to align probes 108 by extending the probes through the first and second arrays of holes.

As best shown in FIG. 2, in some embodiments, probes 108' include one or more raised surfaces 130. One or more raised surfaces 130 on probe 108' releasably secure probe 108' within die head 124.

Inserting nanotube interposer 106 between dielectric plate 104 and integrated circuit 102 allows for a simpler probe and head construction. The individual bundles of nanotubes, i.e., nanotubes 118, compress like springs and provide the necessary compliance. This allows for probes 108 to be straight wire probes, since they no longer have to flex, which greatly simplifies the probe manufacturing process and reduces cost. Straight wires are also much easier to insert into the head, allowing for automated head assembly. Since the wires do not undergo deflection stresses they can be much shorter, which reduces their inductance and allows for higher test frequencies, and also increases their current capacity. It also allows them to be placed closer together to accommodate testing of chips with smaller pads and tighter pad pitches.

Probe 108 can be custom-sized. In some embodiments, carbon nanotube bundles 118 are formed in an array having radial spacing of less than 100 nm, each of the carbon nanotube bundles has a height less than 0.508 mm (20 mil in non-Si units), each of the carbon nanotube bundles has stiffness less than 8 grams per 0.025 mm (8 grams per mil in non-Si units) of compression. In some embodiments, the uniform thickness of each probe shaft 108 is between about 0.0508 mm (about 2 mils in non-Si units) and about 0.127 mm (about 5 mils in non-Si units).

Assemblies and probes according to the disclosed subject matter offer advantages over known designs. Assemblies according to the disclosed subject matter allow for the use shorter, straight manufactured contacts/probes, which will allow for higher currents and less inductance. Straight probes allow for automated insertion of the probes, which results in faster assembly and shorter lead-times. The use of manufactured probes rather than nanotube bundle probes maintains head reparability.

The use of straight probes increases accuracy and alignment and allows for smaller geometries of contact and interface, which helps reduce shorting. Some embodiments include a less than 0.0127 mm (0.5 mil in non-Si units) radial alignment.

Assemblies according to the disclosed subject matter provide finer pitch solutions. As mentioned above, the nanotubes in the nanotube interposer can be grown to a desired size, e.g., custom width and height, and can have contacts that are 0.508 mm (20 mils in non-Si units) long or smaller. The nanotubes are compliant, i.e., able to accommodate wafer/bump height variations, allow for larger arrays, have no contact gap, and lower grams per 0.025 mm (grams per mil in non-Si units), e.g., less than 8 grams total per contact. As a result, the electrical contacts or pads on the multi-layered dielectric plate (or multi-layered ceramic (MLC) do not wear as quickly and no re-plating is required.

Compared to conventional probe card heads, no probe insulation or coating is required. Nanotube interposers can be manufactured quickly at a high volume and a low cost. Nanotube interposers are suitable for fine pitch applications, higher frequency applications, and broader temperature ranges.

Although the disclosed subject matter has been described and illustrated with respect to embodiments thereof, it should be understood by those skilled in the art that features of the disclosed embodiments can be combined.

## Claims

1. A probe card assembly (100) for testing circuit boards comprising:
a multi-layered dielectric plate (104) aligned with an integrated circuit (102), said integrated circuit (102) having arrayed upon its surface (110) a first plurality of electrical contacts (112) arranged in a pattern, said dielectric plate (104) having arrayed upon its surface (114) a second plurality of electrical contacts (116) arranged in a pattern matching said first plurality of electrical contacts (112);
a carbon nanotube interposer (106) interposed between said dielectric plate (104) and said integrated circuit (102), said nanotube interposer (106) having compliant carbon nanotubes (118) that are arranged to match the pattern of electrical contacts (112) on said integrated circuit (102) and said dielectric plate (104); and
a plurality of non-compliant vertical probes (108; 108') arrayed in a pattern upon said nanotube interposer (106) and joined with said nanotubes (118), said vertical probes (108; 108') making electrical contact with said first plurality of electrical contacts (112) and said second plurality of electrical contacts (116) via said carbon nanotubes (118);
**characterized in that**
the non-compliant vertical probes (108; 108') are straight wire probes.

2. A probe card assembly (100) according to claim 1, wherein each of said carbon nanotubes (118) serves as an electrical conduit between said vertical probes (108; 108') and said second plurality of electrical contacts (116).

3. A probe card assembly (100) according to claim 1 or 2, further comprising:
an assembly aid film (120) having a first array of holes (122); and
a die head (124) including a second array of holes (128);
wherein said probes (108; 108') extend through said first and second arrays of holes (128).

4. A probe card assembly (100) according to claim 1 or according to claim 3 not depending on claim 2, wherein said carbon nanotubes (118) are formed in an array having radial spacing of less than 0.0127 mm.

5. A probe card assembly (100) according to claim 1 or according to claim 3 not depending on claim 2, wherein each of said carbon nanotubes (118) has a height and width less than 0.0254 mm.

6. A probe card assembly (100) according to claim 1 or according to claim 3 not depending on claim 2, wherein each of said carbon nanotubes (118) has a stiffness of less than 8 grams per 0.0254 mm.

7. A probe card assembly (100) according to claim 1 or according to claim 3 not depending on claim 2, wherein each of said probes (108; 108') includes one or more raised surfaces (130).

## Patentansprüche

1. Sondenkartenanordnung (100) zum Testen von Leiterplatten, umfassend:
eine mehrschichtige dielektrische Platte (104), welche mit einem integrierten Schaltkreis (102) ausgerichtet ist, wobei der integrierte Schaltkreis (102) auf seiner Oberfläche (110) eine erste Mehrzahl elektrischer Kontakte (112) angeordnet aufweist, welche in einem Muster angeordnet sind, wobei die dielektrische Platte (104) auf ihrer Oberfläche (114) eine zweite Mehrzahl elektrischer Kontakte (116) angeordnet aufweist, welche in einem Muster angeordnet sind, welches der ersten Mehrzahl elektrischer Kontakte (112) entspricht;
ein Kohlenstoffnanoröhren-Zwischenelement (106), welches zwischen der dielektrischen Platte (104) und der integrierten Schaltung (102) eingefügt ist, wobei das Nanoröhren-Zwischenelement (106) nachgiebige Kohlenstoffnanoröhren (118) aufweist, welche derart angeordnet sind, dass sie dem Muster elektrischer Kontakte (112) an der integrierten Schaltung (102) und der dielektrischen Platte (104) entsprechen; und
eine Mehrzahl nicht-nachgiebiger vertikaler Sonden (108; 108'), welche in einem Muster auf dem Nanoröhren-Zwischenelement (106) angeordnet und mit den Nanoröhren (118) verbunden sind, wobei die vertikalen Sonden (108; 108') einen elektrischen Kontakt mit der ersten Mehrzahl elektrischer Kontakte (112) und der zweiten Mehrzahl elektrischer Kontakte (116) über die Kohlenstoffnanoröhren (118) herstellen;
**dadurch gekennzeichnet, dass**
die nicht-nachgiebigen vertikalen Sonden (108; 108') gerade Drahtsonden sind.

2. Sondenkartenanordnung (100) nach Anspruch 1, wobei jede der Kohlenstoffnanoröhren (118) als ein elektrischer Leiter zwischen den vertikalen Sonden (108; 108') und der zweiten Mehrzahl elektrischer Kontakte (116) dient.

3. Sondenkartenanordnung (100) nach Anspruch 1 oder 2, ferner umfassend:
einen Montagehilfsfilm (120), welcher eine erste Anordnung von Löchern (122) aufweist; und
einen Werkzeugkopf (124), welcher eine zweite Anordnung von Löchern (128) umfasst;
wobei sich die Sonden (108; 108') durch die erste und die zweite Anordnung von Löchern (128) erstrecken.

4. Sondenkartenanordnung (100) nach Anspruch 1 oder nach Anspruch 3, sofern dieser nicht auf Anspruch 2 rückbezogen ist, wobei die Kohlenstoffnanoröhren (118) in einer Anordnung ausgebildet sind, welche einen radialen Abstand von weniger als 0,0127 mm aufweist.

5. Sondenkartenanordnung (100) nach Anspruch 1 oder nach Anspruch 3, sofern dieser nicht auf Anspruch 2 rückbezogen ist, wobei jede der Kohlenstoffnanoröhren (118) eine Höhe und eine Breite von weniger als 0,0254 mm aufweist.

6. Sondenkartenanordnung (100) nach Anspruch 1 oder nach Anspruch 3, sofern dieser nicht auf Anspruch 2 rückbezogen ist, wobei jede der Kohlenstoffnanoröhren (118) eine Steifigkeit von weniger als 8 Gramm pro 0,0254 mm aufweist.

7. Sondenkartenanordnung (100) nach Anspruch 1 oder nach Anspruch 3, sofern dieser nicht auf Anspruch 2 rückbezogen ist, wobei jede der Sonden (108; 108') eine oder mehrere erhöhte Oberflächen (130) aufweist.

## Revendications

1. Ensemble de carte de sonde (100) pour tester des cartes de circuits comprenant :
une plaque diélectrique multicouche (104) alignée avec un circuit intégré (102), ledit circuit intégré (102) ayant en réseau sur sa surface (110) une première pluralité de contacts électriques (112) agencés selon un motif, ladite plaque diélectrique (104) ayant en réseau sur sa surface (114) une seconde pluralité de contacts électriques (116) agencés selon un motif correspondant à ladite première pluralité de contacts électriques (112) ;
un élément d'interposition à nanotubes de carbone (106) interposé entre ladite plaque diélectrique (104) et ledit circuit intégré (102), ledit élément d'interposition à nanotubes (106) ayant des nanotubes de carbone élastiques (118) qui sont agencés pour correspondre au motif de contacts électriques (112) sur ledit circuit intégré (102) et ladite plaque diélectrique (104) ; et
une pluralité de sondes verticales non élastiques (108 ; 108') en réseau selon un motif sur ledit élément d'interposition à nanotubes (106) et jointes auxdits nanotubes (118), lesdites sondes verticales (108 ; 108') établissant un contact électrique avec ladite première pluralité de contacts électriques (112) et ladite seconde pluralité de contacts électriques (116) par l'intermédiaire desdits nanotubes de carbone (118) ;
**caractérisé en ce que**
les sondes verticales non élastiques (108 ; 108') sont des sondes à fil droit.

2. Ensemble de carte de sonde (100) selon la revendication 1, dans lequel chacun desdits nanotubes de carbone (118) sert de conduit électrique entre lesdites sondes verticales (108 ; 108') et ladite seconde pluralité de contacts électriques (116).

3. Ensemble de carte de sonde (100) selon la revendication 1 ou 2, comprenant en outre :
un film d'aide à l'assemblage (120) ayant un premier réseau de trous (122) ; et
une tête de filière (124) incluant un second réseau de trous (128) ;
dans lequel lesdites sondes (108 ; 108') s'étendent à travers lesdits premier et second réseaux de trous (128).

4. Ensemble de carte de sonde (100) selon la revendication 1 ou selon la revendication 3 non dépendante de la revendication 2, dans lequel lesdits nanotubes de carbone (118) sont formés en un réseau ayant un espacement radial inférieur à 0,0127 mm.

5. Ensemble de carte de sonde (100) selon la revendication 1 ou selon la revendication 3 non dépendante de la revendication 2, dans lequel chacun desdits nanotubes de carbone (118) a une hauteur et une largeur inférieures à 0,0254 mm.

6. Ensemble de carte de sonde (100) selon la revendication 1 ou selon la revendication 3 non dépendante de la revendication 2, dans lequel chacun desdits nanotubes de carbone (118) a une raideur inférieure à 8 grammes pour 0,0254 mm.

7. Ensemble de carte de sonde (100) selon la revendication 1 ou selon la revendication 3 non dépendante de la revendication 2, dans lequel chacune desdites sondes (108 ; 108') inclut une ou plusieurs surfaces surélevées (130).
